# EUROPÄISCHE PATENTSCHRIFT

(11) **EP 2 320 716 B1**
(45) Veröffentlichungstag und Bekanntmachung des Hinweises auf die Patenterteilung: **21.06.2017**
(21) Anmeldenummer: 10189371.7
(22) Anmeldetag: 29.10.2010
(51) Int. Cl.: H05K 1/00, H01H 85/046, H01H 85/46, H05K 1/02, H05K 3/22, H01H 85/02

(54) **Schutzeinrichtung für eine Leiterplatte**
Protective device for a circuit board
Dispositif de protection pour une plaque conductrice

(30) Priorität: 06.11.2009 DE 102009046486
(43) Veröffentlichungstag der Anmeldung: 11.05.2011
(73) Patentinhaber: Robert Bosch GmbH, 70442 Stuttgart (DE)
(72) Erfinder: Rychlak, Stefan, 31241 Ilsede (DE)

(56) Entgegenhaltungen:
- WO-A1-01/59799
- WO-A1-2005/086196
- DE-A1- 4 028 978
- DE-T2- 69 812 179
- JP-A- H1 075 064
- "Soldering pins to printed circuit boards", IBM TECHNICAL DISCLOSURE BULLETIN, [Online] vol. 25, no. 8, January 1983 (1983-01), pages 4367-4368, XP1490669,

## Beschreibung

### Stand der Technik

Die Erfindung betrifft ein Verfahren zum Reparieren einer Leiterplatte mit einer Schutzeinrichtung nach Anspruch 1. Eine Schutzeinrichtung für eine Leiterplatte nach Anspruch 1 ist aus der WO 2005/086196 A1 bekannt. Bei der bekannten Schutzeinrichtung ist ein Bauelement in Form einer Schmelzsicherung vorgesehen, welche beim Auftreten eines überhöhten Stromes eine Unterbrechung der Stromführung bewirkt. Die Schmelzsicherung ist dabei im Bereich von mit der Leiterbahn verbundenen Durchkontaktierungen angeordnet.

Aus der DE 40 28 978 A1 ist es darüber hinaus bekannt, im Bereich von Durchkontaktierungen Ladeflächen vorzusehen, die eine Vergrößerung der Kontaktfläche zu einem elektrischen Bauelement ausbilden, um die elektrische Verbindung mit dem Bauelement besonders einfach ausbilden zu können.

Weiterhin ist es allgemein bekannt, bei Leiterplatten Schutzeinrichtungen in Form von Schmelzsicherungen einzusetzen, welche beispielsweise auf einer Leiterplattenoberseite oder -unterseite in Form von als SMD-Bauteilen ausgebildeten Schmelzsicherungen angeordnet sind. Sollte es während des Betriebs eines elektrischen Gerätes, welches mit einer entsprechenden Schutzeinrichtung für die Leiterplatte versehen ist, zu einem überhöhten Strom, zum Beispiel infolge eines Kurzschlusses kommen, so schmilzt die Sicherung durch und diese kann anschließend durch eine neue Sicherung ersetzt werden. Das bedeutet, dass die Schutzeinrichtung für die Leiterplatte bereits während des Herstellprozesses der Leiterplatte mit der bzw. den entsprechenden Sicherungen versehen werden muss, was relativ kostenintensiv ist.

Weiterhin ist aus der EP 1 811 819 A1 eine Lösung bekannt, bei der auf einer Leiterplatte eine Reihe von als Schmelzsicherungen ausgebildeten Sensoren angeordnet sind, um die Temperatur in unterschiedlichen Bereichen der Leiterplatte überwachen zu können bzw. beim Überschreiten der Temperatur durch Durchschmelzen der Sicherungen eine Beschädigung zu vermeiden.

### Offenbarung der Erfindung

Ausgehend von dem dargestellten Stand der Technik liegt der Erfindung die Aufgabe zugrunde, eine Schutzeinrichtung für eine Leiterplatte nach dem Oberbegriff des Anspruchs 1 derart weiterzubilden, dass diese im Reparaturfall besonders einfach und wirtschaftlich sowie zuverlässig repariert werden kann. Diese Aufgabe wird erfindungsgemäß bei einer Schutzeinrichtung für eine Leiterplatte mit den Merkmalen des Anspruchs 1 gelöst. Um als Ersatz für die durchgetrennte Leiterbahn eine definierte Einstellung der Schutzeinrichtung zu ermöglichen, ist es vorgesehen, dass das elektrische Bauelement ein Widerstand ist. Somit kann über den Widerstandswert ähnlich wie über die Wahl der Querschnittsfläche der Leiterbahn eine neue (Ersatz-)Sicherung geschaffen werden, welche den im Querschnitt reduzierten Bereich der ursprünglichen Leiterbahn ersetzen kann.

Vorteilhafte Weiterbildungen der erfindungsgemäßen Schutzeinrichtung für eine Leiterplatte sind in den Unteransprüchen angegeben.

Es kann auch vorgesehen sein, dass der Widerstand ein als Brücke ausgebildeter 0-Ohm Widerstand bzw. eine Drahtbrücke ist. Dies kann beispielsweise dann vorteilhaft sein, wenn die Leiterplatte mehrere Schutzeinrichtungen trägt, sodass die Funktion der Schutzeinrichtung durch eine andere Schutzeinrichtung ersetzt werden soll.

Um weitergehende Beschädigungen der Leiterplatte, welche insbesondere durch einen möglichen Brand entstehen könnten, zu vermeiden, ist es darüber hinaus in einer weiteren bevorzugten Ausführungsform der Erfindung vorgesehen, dass zumindest die unmittelbar oberhalb und unterhalb der Innenlage angeordneten Leiterplattenlagen zumindest in dem in der Querschnittfläche reduzierten Bereich der Leiterbahn derart ausgebildet sind, dass diese beim Ansprechen des Bereichs keine Brandstellen erzeugen. Dies kann beispielsweise dadurch erreicht werden, dass die unmittelbar oberhalb und unterhalb der Innenlage angeordneten Leiterplattenlagen die Innenlage möglichst luftdicht überdecken. Somit ist die Gefahr zur Entstehung eines Brandes durch Ausschluss einer hierfür notwendigen Sauerstoffzufuhr, beispielsweise aus der Umgebungsluft, ausgeschlossen, zumindest stark reduziert. Ebenso denkbar sind Leiterplattenmaterialien zu verwenden, die nur eine geringe Brennneigung aufweisen. Hierzu sind in der Regel die meisten üblich bekannten Leiterplattenmaterialien geeignet. Insbesondere eignen sich Epoxidharze, ebenso Epoxidharze mit einem Glasfasergewebe, insbesondere einem wärmebeständigen Glasfasergewebe. Als Leiterplatten im Sinne der Erfindung sind jegliche Arten von mehrlagigen Trägersubstraten mit wenigstens eine Leiterbahn aufweisenden Innenlage zu verstehen. Denkbar sind somit auch Keramikschaltungen. Ebenso kommen allgemein auch Hybridschaltungen in Frage. Geeignet sind auch andere vergleichbare mehrlagige Trägersubstrate, wobei zumindest der Bereich des als Sicherung vorgesehenen Leiterbahnabschnitts in der Innenlage durch eine obere und eine untere Leiterplattenlage, insbesondere luftdicht, überdeckt ist.

Eine umfassende Absicherung der Leiterplatte in verschiedenen Bereichen der Leiterplatte ist möglich, wenn mehrere im Querschnitt reduzierte Leiterbahnen im Bereich der Innenlage angeordnet sind. Dabei ist es auch denkbar, dass die reduzierten Querschnittsflächen der Leiterbahnen jeweils individuell angepasst werden.

Besonders einfach lässt sich die Sicherungseinrichtung den jeweils erforderlichen Gegebenheiten anpassen, wenn die Reduktion der Querschnittsfläche des Bereichs über eine Reduktion der Breite der Leiterbahn eingestellt ist.

Der Einsatz einer derartigen mit einer Schutzeinrichtung versehenen Leiterplatte ist besonders bevorzugt bei einem elektrischen Gerät vorgesehen, welches insbesondere als Steuergerät in einem Kraftfahrzeug ausgebildet ist.

Die Erfindung umfasst auch eine elektrisches Gerät, insbesondere ein Steuergerät in einem Kraftfahrzeug, mit einer erfindungsgemäßen Schutzeinrichtung sowie ein Verfahren zum Reparieren einer Leiterplatte, die eine erfindungsgemäße Schutzeinrichtung aufweist. Bei dem erfindungsgemäßen Verfahren ist es vorgesehen, dass bei einer Unterbrechung der Stromführung durch eine Leiterbahn ein als Widerstand ausgebildetes elektronisches Bauelement mit Durchkontaktierungen verbunden wird, das die Leiterbahn zwischen den Durchkontaktierungen überbrückt.

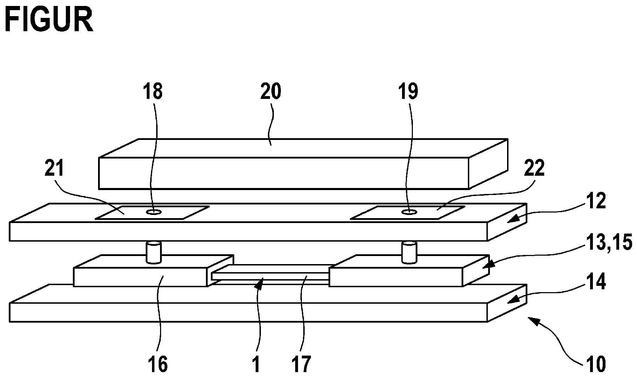

Weitere Vorteile, Merkmale und Einzelheiten der Erfindung ergeben sich aus der nachfolgenden Beschreibung eines bevorzugten Ausführungsbeispiels sowie anhand der Zeichnung.

Diese zeigt in der einzigen:
- Figur: eine Explosionsdarstellung eines Bereichs einer Leiterplatte mit einer erfindungsgemäßen Schutzeinrichtung.

In der Figur ist eine Leiterplatte 10 dargestellt, welche Bestandteil eines elektrischen Gerätes, insbesondere eines Steuergerätes in einem Kraftfahrzeug ist.

Das Steuergerät im Kraftfahrzeug dient beispielsweise zur Steuerung von Motorfunktionen oder ähnlichem. Die lediglich ausschnittsweise dargestellte Leiterplatte 10, die eine nicht dargestellte elektrische oder elektronische Schaltung trägt, besteht im Ausführungsbeispiel aus drei Leiterplattenlagen 12 bis 14. Hierbei ist die mittlere Leiterplattenlage 13 als Innenlage 15 ausgebildet. Die Innenlage 15 ist von der oberen Leiterplattenlage 12 sowie der unteren Leiterplattenlage 14 vollflächig überdeckt. Selbstverständlich ist es auch möglich, anstelle von drei Leiterplattenlagen 12 bis 14 eine größere Anzahl von Leiterplattenlagen vorzusehen, um die Leiterplatte 10 auszubilden. Die Leiterplatte kann beispielsweise aus einem Epoxidharz mit einem eingelagerten Glasfasergewebe ausgebildet sein. Ebenso denkbar ist ein mehrlagiges Keramiksubstrat oder andere bekannte mehrlagig ausgeführten Trägersubstrate.

Erfindungswesentlich ist, dass die Innenlage 15 eine Schutzeinrichtung 1 aufweist, die im Falle eines überhöhten Stromes, typischerweise in Folge eines Kurzschlusses, die Leiterplatte 10 vor weitergehenden Schäden, insbesondere vor einer Beschädigung der sie tragenden elektrischen bzw. elektronischen Bauteile schützt. Hierzu ist die Schutzeinrichtung 1 als Teil einer Leiterbahn 16 der Innenlage 15 ausgebildet. Dabei kann es vorgesehen sein, dass die Leiterbahn 16 eine Leiterbahn ist, die der Stromversorgung der Leiterplatte 10 dient. Alternativ hierzu ist es auch denkbar, dass die Leiterbahn 16 der Stromversorgung eines oder mehrerer auf der Leiterplatte 10 angeordneter Bauteile dient. Um die Bauteile bzw. Bauteilgruppen auf der Leiterplatte 10 umfassend zu schützen, kann es darüber hinaus vorgesehen sein, dass mehrere Schutzeinrichtungen 1 in der Innenlage 15 der Leiterplatte 10 angeordnet bzw. ausgebildet sind.

Die Leiterbahn 16 weist im Bereich 17 der Schutzeinrichtung 1 eine reduzierte Querschnittsfläche auf. Diese reduzierte Querschnittsfläche kann über eine Reduktion der Höhe der Leiterbahn 16, eine Reduktion der Breite der Leiterbahn 16 oder einer Kombination bzw. einer Reduktion sowohl der Höhe als auch der Breite der Leiterbahn 16 erfolgen, wie dies im Ausführungsfall im Bereich 17 dargestellt ist. Da der Strom über die Leiterbahn 16 fließt, ist das Maß der reduzierten Querschnittsfläche ein Maß für das Ansprechverhalten der Schutzeinrichtung 1 derart, dass je geringer die Querschnittsfläche im Bereich 17 der Schutzeinrichtung 1 bzw. der Leiterbahn 16 gewählt ist, desto geringer ist der Strom, der ohne eine Beschädigung der Leiterbahn 16 im Bereich 17 der Schutzeinrichtung 10 fließen kann.

Die Innenlage 15 sowie die obere Leiterplattenlage 12 weisen unmittelbar vor dem Bereich 17 der Schutzeinrichtung 1 Durchkontaktierungen 18, 19 auf. Die Durchkontaktierungen 18, 19 reichen bis an die Oberseite der oberen Leiterplattenlage 12, welche im Bereich der dort mündenden Durchkontaktierungen 18, 19 nach dem Herstellungsprozess einen Freiraum aufweist, d.h. ohne Bauteile ausgebildet ist. Insbesondere ist der Bereich der oberen Leiterplattenlage 12 im Bereich der Durchkontaktierungen 18, 19 derart ausgebildet, dass es möglich ist, die beiden Durchkontaktierungen 18, 19 im Reparaturfall mittels eines elektrischen Bauelements 20 zu überbrücken. Hierzu kann es vorgesehen sein, dass an der Oberseite der oberen Leiterplattenlage 12 Landeflächen 21, 22 zur Verbindung mit dem Bauelement 20 ausgebildet sind.

Das Bauelement 20 kann hierbei als Widerstand mit einem definierten Widerstandswert ausgebildet sein oder aber als 0-Ohm-Brücke bzw. Drahtbrücke.

Weiterhin wird erwähnt, dass die die Innenlage 15 sandwichartig umschließende untere Leiterplattenlage 14 sowie die obere Leiterplattenlage 12 zumindest im Bereich 17 der Schutzeinrichtung 1, in der die Leiterbahn 16 hinsichtlich ihrer Querschnittsfläche reduziert ist, derart ausgebildet ist, dass sie beispielsweise aus einem Material besteht, welches im Falle des Durchschmelzens des Leiterbahn 16 im Bereich 17 der Schutzeinrichtung 1 nicht zu Brandstellen neigt bzw. nicht entzündet wird. Ebenso ist eine Brandneigung unterbunden oder zumindest stark reduziert, indem zumindest im Bereich der Schutzeinrichtung 1, welcher als Sicherung ausgebildet ist, die Innenlage 15 durch die obere Leiterplattenlage 12 und die untere Leiterplattenlage 14 luftdicht überdeckt ist. Insbesondere ist eine Sauerstoffzufuhr in diesen als Sicherung ausgebildeten Bereich zu unterbinden.

Beim Herstellungsprozess der Leiterplatte 10 wird die Leiterplatte 10 ohne das Bauelement 20 bestückt. Sollte es beim Betrieb zu einer Stromüberlast bzw. zu einem Kurzschluss im Bereich 17 der Leiterplatte 10 kommen, so spricht die Schutzeinrichtung 1 an, indem der in seiner Querschnittsfläche reduzierte Bereich 17 der Leiterbahn 16 durchschmilzt und somit eine Stromunterbrechung bewirkt.

Um die Leiterplatte 10 zu reparieren, ist es vorgesehen, dass diese mittels des Bauelementes 20 bestückt werden kann, welches die Durchkontaktierungen 18, 19 miteinander elektrisch verbindet und somit für eine Überbrückung des Bereichs 17 sorgt. Durch einen definierten Wert beispielsweise eines Widerstandes kann hierbei dieselbe Funktion bzw. dasselbe Ansprechverhalten der Schutzeinrichtung 1 auch nach dem Reparaturfall bewirkt werden.

## Patentansprüche

1. Verfahren zum Reparieren einer Leiterplatte (10), wobei die Leiterplatte (10) mehrere Leiterplattenlagen (12 bis 14) aufweist, wovon wenigstens eine Lage eine wenigstens eine Leiterbahn (16) aufweisende Innenlage (15) ist, wobei die Leiterbahn (16) einen in der Querschnittsfläche reduzierten Bereich (17) als Schutzeinrichtung (1) aufweist, wobei der Bereich (17) beim Auftreten eines überhöhten Stromes eine Unterbrechung der Stromführung durch die Leiterbahn (16) bewirkt, wobei die Innenlage (15) zumindest im Bereich (17) von einer oberen und einer unteren Leiterplattenlage (12, 14) überdeckt ist, wobei vorzugsweise an beiden Übergangsbereichen der Leiterbahn (16) zu ihrem in der Querschnittsfläche reduzierten Bereich (17) die Leiterbahn (16) Durchkontaktierungen (18, 19) bis auf die Ebene der Leiterplattenoberseite oder der Leiterplattenunterseite aufweist, und wobei der Bereich der Durchkontaktierungen (18, 19) an der Leiterplattenoberseite oder der Leiterplattenunterseite leiterbahnfrei ausgebildet ist,
**dadurch gekennzeichnet,**
**dass** bei einer Unterbrechung der Stromführung durch den in der Querschnittsfläche reduzierten Bereich (17) der Leiterbahn (16) ein als Widerstand ausgebildetes elektronisches Bauelement (20) mit Landeflächen (21, 22) an den Durchkontaktierungen (18, 19) verbunden wird, wobei das Bauelement (20) die Leiterbahn (16) zwischen den Durchkontaktierungen (18, 19) überbrückt.

2. Verfahren nach Anspruch 1,
**dadurch gekennzeichnet,**
**dass** als das Bauelement (20) ein 0-Ohm Widerstand verwendet wird.

3. Verfahren nach Anspruch 1 oder 2,
**dadurch gekennzeichnet,**
**dass** zumindest die unmittelbar oberhalb und unterhalb der Innenlage (15) angeordneten Leiterplattenlagen (12, 14) zumindest in dem in der Querschnittfläche reduzierten Bereich (17) der Leiterbahn (16) derart ausgebildet werden, dass diese beim Ansprechen des Bereichs (17) keine Brandstellen erzeugen.

4. Verfahren nach einem der Ansprüche 1 bis 3,
**dadurch gekennzeichnet,**
**dass** mehrere in ihrem Querschnitt reduzierte Leiterbahnen (16) im Bereich der Innenlage (15) angeordnet sind.

5. Verfahren nach einem der Ansprüche 1 bis 4,
**dadurch gekennzeichnet,**
**dass** die Reduktion der Querschnittsfläche der Leiterbahn (16) im Bereich (17) über eine Reduktion der Breite der Leiterbahn (16) eingestellt wird.

## Claims

1. Method for repairing a printed circuit board (10), wherein the printed circuit board (10) has a plurality of printed circuit board layers (12 to 14), of which at least one layer is an inner layer (15) which has at least one conductor track (16), wherein the conductor track (16) has a region (17) of reduced cross-sectional area as protection device (1), wherein the region (17) causes an interruption in the current flow through the conductor track (16) when an elevated current occurs, wherein the inner layer (15), at least in the region (17), is covered by an upper and a lower printed circuit board layer (12, 14), wherein, preferably at the two transition regions of the conductor track (16) to the region (17) of reduced cross-sectional area of the said conductor track, the conductor track (16) has plated-through holes (18, 19) as far as the level of the printed circuit board top side or the printed circuit board bottom side, and wherein the region of the plated-through holes (18, 19) is formed without conductor tracks on the printed circuit board top side or the printed circuit board bottom side,
**characterized**
**in that**, in the event of an interruption in the current flow through the region (17) of reduced cross-sectional area of the conductor track (16), an electronic component (20), which is in the form of a resistor, is connected to landing areas (21, 22) on the plated-through holes (18, 19), wherein the component (20) bridges the conductor track (16) between the plated-through holes (18, 19).

2. Method according to Claim 1,
**characterized**
**in that** a 0 ohm resistor is used as the component (20).

3. Method according to Claim 1 or 2,
**characterized**
**in that** at least the printed circuit board layers (12, 14) which are arranged immediately above and below the inner layer (15) are formed at least in the region,(17) of reduced cross-sectional area of the conductor track (16) in such a way that the said printed circuit board layers do not generate any fire points when the region (17) responds.

4. Method according to one of Claims 1 to 3,
**characterized**
**in that** a plurality of conductor tracks (16) of reduced cross section are arranged in the region of the inner layer (15).

5. Method according to one of Claims 1 to 4,
**characterized**
**in that** the reduction in the cross-sectional area of the conductor track (16) in the region (17) is adjusted by means of a reduction in the width of the conductor track (16).

## Revendications

1. Procédé pour réparer un circuit imprimé (10), le circuit imprimé (10) possédant plusieurs couches de circuit imprimé (12 à 14), dont au moins une couche est une couche interne (15) qui possède au moins une piste conductrice (16), la piste conductrice (16) possédant une zone (17) à la surface de section transversale réduite qui fait office de dispositif de protection (1), la zone (17) provoquant une interruption du passage du courant à travers la piste conductrice (16) dans le cas où il se produit un courant excessif, la couche interne (15) étant recouverte au moins dans une zone (17) par couche de circuit imprimé (12, 14) supérieure et une inférieure, la piste conductrice (16) possédant, de préférence au niveau des deux zones de transition de la piste conductrice (16) vers sa zone (17) à la surface de section transversale réduite, des contacts traversants (18, 19) jusqu'au niveau du côté supérieur du circuit imprimé ou du côté inférieur du circuit imprimé, et la zone des contacts traversants (18, 19) étant réalisée dépourvue de piste conductrice sur le côté supérieur du circuit imprimé ou sur le côté inférieur du circuit imprimé,
**caractérisé en ce**
**que** dans le cas d'une interruption du passage du courant à travers la zone (17) à la surface de section transversale réduite de la piste conductrice (16), un composant électronique (20) réalisé sous la forme d'une résistance et muni de surfaces d'application (21, 22) est relié aux contacts traversants (18, 19), le composant (20) pontant la piste conductrice (16) entre les contacts traversants (18, 19).

2. Procédé selon la revendication 1, **caractérisé en ce que** le composant (20) utilisé est une résistance de 0 ohm.

3. Procédé selon la revendication 1 ou 2, **caractérisé en ce qu'**au moins les couches de circuit imprimé (12, 14) qui sont disposées au-dessus et au-dessous de la couche interne (15) sont configurées, dans la zone (17) à la surface de section transversale réduite du circuit imprimé (16), de telle sorte que celles-ci ne produisent aucun point de combustion en cas de réaction de la zone (17).

4. Procédé selon l'une des revendications 1 à 3, **caractérisé en ce que** plusieurs pistes conductrices (16) à la section transversale réduite sont disposées dans la zone de la couche interne (15).

5. Procédé selon l'une des revendications 1 à 4, **caractérisé en ce que** la réduction de la surface de section transversale de la piste conductrice (16) dans la zone (17) est réglée par le biais d'une réduction de la largeur de la piste conductrice (16).
